# EUROPEAN PATENT APPLICATION

(11) **EP 4 693 807 A1**
(43) Date of publication of application: **11.02.2026**
(21) Application number: 25190422.3
(22) Date of filing: 18.07.2025
(51) Int. Cl.: H02J 7/00, G01R 31/374, G01R 31/382, H01M 10/42, G01R 31/392

(54) **APPARATUS AND METHOD FOR GENERATING OPEN CIRCUIT VOLTAGE PROFILE**

(30) Priority: 08.08.2024 KR 20240106122
(71) Applicant: SAMSUNG SDI CO., LTD., Yongin-si, Gyeonggi-do 17084 (KR)
(72) Inventor: CHO, Young Shin, 16678 Suwon-si, Gyeonggi-do (KR); SIM, Se Sub, 16678 Suwon-si, Gyeonggi-do (KR)
(74) Representative: Gulde & Partner

(57) **Abstract**

The present disclosure relates to an apparatus (100,200) and method for generating an open circuit voltage, OCV, profile, and a problem to be solved is to generate an OCV profile according to a battery cell that has degraded under actual use conditions, thereby reducing errors in calculations of a state of charge, SOC, a state of health, SOH, or the like. To this end, the present disclosure provides a configuration for generating a charging profile by charging a battery cell, analyzing the charging profile to derive degradation information of the battery cell, and generating the OCV profile of the battery cell based on the degradation information.

## Description

### FIELD

The present disclosure relates to an apparatus and method for generating an open circuit voltage (OCV) profile.

### BACKGROUND

Batteries applied to large-capacity systems such as electric vehicles or energy storage systems (ESSs) require long life, high output characteristics, and safety due to the characteristics of large-capacity systems. To this end, it is very important to estimate the state of a battery.

In order to estimate the state of the battery, an open circuit voltage (OCV) or a state of charge (SOC) is used. An OCV profile corresponding to each SOC is a basic and essential parameter used in calculations of the SOC and state of health (SOH).

Since the OCV profile changes as the battery degrades, when the OCV profile obtained at beginning-of-life (BOL) is applied to a degraded battery, errors in calculations of the SOC, the SOH, and the like increases. In addition, the OCV profile is difficult to obtain in an actual use environment because the OCV profile requires long-term evaluation and strict charging/discharging protocols.

To solve this problem, there are cases where a pre-evaluated OCV profile of a middle-of-life (MOL) stage or end-of-life (EOL) stage is utilized, but there is a problem that preliminary evaluation of battery life requires a lot of time and resources, and there is a limitation in the representativeness of the preliminary evaluation of battery life.

The herein-described information disclosed in Discussion of Related Art is only intended to improve understanding of the background of the present disclosure, and therefore may include information that does not constitute related art.

The above information disclosed in this Background section is for enhancement of understanding of the background of the present disclosure, and therefore, it may contain information that does not constitute related (or prior) art.

### SUMMARY

The present disclosure is directed to providing an apparatus and method for generating an open circuit voltage (OCV) profile, which generate an OCV profile according to a battery cell that has degraded under actual use conditions so as to reduce errors in calculations of a state of charge (SOC), a state of health (SOH), or the like.

However, objects that the present disclosure intends to achieve are not limited to the herein-described objects and other objects that are not described may be clearly understood by those skilled in the art from the following description.

According to aspects of the present disclosure, there is provided an apparatus for generating an OCV profile, which includes a battery management system that generates a charging profile by charging a battery cell and an OCV profile generation module that analyzes the charging profile to derive degradation information of the battery cell and generates the OCV profile of the battery cell based on the degradation information.

### BRIEF DESCRIPTION OF THE DRAWINGS

The following drawings attached to this specification illustrate embodiments of the present disclosure, and further describe aspects and features of the present disclosure together with the detailed description of the present disclosure. Thus, the present disclosure should not be construed as being limited to the drawings, in which:
FIG. 1 is a diagram illustrating a battery module according to embodiments of the present disclosure;
FIGS. 2A and 2B are diagrams illustrating a battery pack according to embodiments of the present disclosure;
FIG. 3 illustrates a block diagram of an apparatus for generating an open circuit voltage (OCV) profile according to embodiments of the present disclosure;
FIG. 4 illustrates a block diagram of a battery management system according to embodiments of the present disclosure;
FIG. 5 illustrates a block diagram of a processor according to embodiments of the present disclosure;
FIG. 6 illustrates a flowchart of a method of generating an OCV profile according to embodiments of the present disclosure;
FIG. 7 illustrates a flowchart of a charging profile generation process according to embodiments of the present disclosure;
FIG. 8 illustrates a block diagram of an apparatus for generating an OCV profile according to embodiments of the present disclosure; and
FIG. 9 illustrates a block diagram of an apparatus for generating an OCV according to embodiments of the present disclosure.

### DETAILED DESCRIPTION

Hereinafter, embodiments of the present disclosure will be described, in detail, with reference to the accompanying drawings. The terms or words used in this specification and claims should not be construed as being limited to the usual or dictionary meaning and should be interpreted as meaning and concept consistent with the technical idea of the present disclosure based on the principle that the inventor can be his/her own lexicographer to appropriately define the concept of the term to explain his/her disclosure in the best way.

The embodiments described in this specification and the configurations shown in the drawings are only some of the embodiments of the present disclosure and do not represent all of the technical ideas, aspects, and features of the present disclosure. Accordingly, it should be understood that there may be various equivalents and modifications that can replace or modify the embodiments described herein at the time of filing this application.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the drawings, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed herein could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all subranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

References to two compared elements, features, etc. as being "the same" may mean that they are "substantially the same". Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

When an arbitrary element is referred to as being disposed (or located or positioned) on the "above (or below)" or "on (or under)" a component, it may mean that the arbitrary element is placed in contact with the upper (or lower) surface of the component and may also mean that another component may be interposed between the component and any arbitrary element disposed (or located or positioned) on (or under) the component.

In addition, it will be understood that when an element is referred to as being "coupled," "linked" or "connected" to another element, the elements may be directly "coupled," "linked" or "connected" to each other, or an intervening element may be present therebetween, through which the element may be "coupled," "linked" or "connected" to another element. In addition, when a part is referred to as being "electrically coupled" to another part, the part can be directly connected to another part or an intervening part may be present therebetween such that the part and another part are indirectly connected to each other.

Throughout the specification, when "A and/or B" is stated, it means A, B or A and B, unless otherwise stated. That is, "and/or" includes any or all combinations of a plurality of items enumerated. When "C to D" is stated, it means C or more and D or less, unless otherwise specified.

Prior to a detailed description of the present embodiment, a structure of a battery which is a target of open circuit voltage (OCV) profile generation in the present embodiment will first be schematically described.

### [Battery Module]

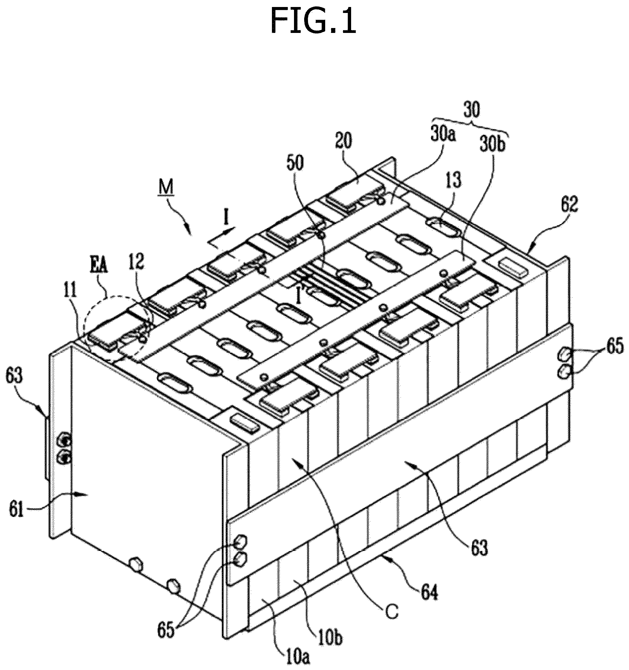

FIG. 1 is a diagram illustrating a battery module according to embodiments of the present disclosure (Although the same reference numerals as those in other drawings may be indicated in FIG. 1, it should be noted that the reference numerals indicated in FIG. 1 are used in a closed manner within FIG. 1).

Referring to FIG. 1, a battery module M according to the present embodiment includes electrode parts 11 and 12, a plurality of battery cells C arranged in one direction, a connection tab 20 connecting a battery cell 10a to an adjacent battery cell 10b, and a protection circuit module 30 of which one end portion on one side thereof is connected to the connection tab 20. The protection circuit module 30 may be a battery management system (BMS). In addition, the connection tab 20 includes a body part 22 that contacts the electrode parts 11 and 12 between adjacent battery cells 10a and 10b and an extension part that extends from the body part 22 and is connected to the protection circuit module 30. The connection tab 20 may be a busbar.

First, the battery cell C may include a battery case and an electrode assembly and electrolyte stored in the battery case. The electrode assembly and the electrolyte react electrochemically to generate energy. On one side of the battery cell C, terminal portions 11 and 12 electrically connected to the connection tab 20 and a vent 13 that is an exhaust passage for gas generated inside the battery cell C may be provided. The terminal portions 11 and 12 of the battery cell C may be a positive terminal 11 and a negative terminal 12 having different polarities, and the terminal portions 11 and 12 of the adj acent battery cells 10a and 10b may be electrically connected in series or in parallel by the connection tab 20 that will be described herein. Meanwhile, in the herein description, an example of the serial connection of the terminal portions 11 and 12 of the battery cells 10a and 10b has been described but is not limited to this structure and it goes without saying that various connection structures may be adopted as needed. In addition, the number and arrangement of the battery cells are not limited to the structure illustrated in FIG. 1 and may be changed as needed.

The plurality of battery cells C may be arranged in one direction so that wide surfaces of the battery cells C face each other, and the arranged plurality of battery cells C may be fixed by a housing including plates 61, 62, 63, and 64. The housing including plates 61, 62, 63, and 64 may include a pair of end plates 61 and 62 facing the wide surfaces of the battery cells C, and a side plate 63 and a bottom plate 64 that connect the pair of end plates 61 and 62. The side plate 63 may support side surfaces of the battery cells C, and the bottom plate 64 may support bottom surfaces of the battery cells C. In addition, the pair of end plates 61 and 62, the side plate 63, and the bottom plate 64 may be connected by members such as bolts 65.

The protection circuit module 30 may mount electronic components, protection circuits, etc., and may be electrically connected to the connection tab 20 that will be described herein. The protection circuit module 30 may include a first protection circuit module 30a and a second protection circuit module 30b that extend at different locations along a direction in which the plurality of battery cells C are arranged. In this case, the first protection circuit module 30a and the second protection circuit module 30b may be spaced a certain distance from each other and positioned parallel to each other, and each of the first protection circuit module 30a and the second protection circuit module 30b may be electrically connected to adjacent connection tabs 20. For a non-limiting example, the first protection circuit module 30a is formed to extend on one side of an upper portion of the plurality of battery cells C in the direction in which the plurality of battery cells C are arranged, and the second protection circuit module 30b is formed to extend on the other side of the upper portion of the plurality of battery cells C in the direction in which the plurality of battery cells C are arranged. In this case, the second protection circuit module 30b may be positioned to be spaced a certain distance from the first protection circuit module 30a with the vent 13 interposed therebetween but may be disposed parallel to the first protection circuit module 30a. In this way, the two protection circuit modules are disposed side by side and spaced apart from each other in the direction in which the plurality of battery cells are arranged, thereby advantageously minimizing an area of a printed circuit board (PCB) constituting the protection circuit module. Unnecessary PCM area is minimized by configuring the protection circuit module into two separate protection circuit modules. In addition, the first protection circuit module 30a and the second protection circuit module 30b may be connected to each other by a conductive connection member 50. In this case, one side of the connection member 50 is connected to the first protection circuit module 30a, and the other side thereof is connected to the second protection circuit module 30b, so that an electrical connection between the two protection circuit modules can be made.

The electrical connection may be made by any one of soldering, resistance welding, laser welding, or projection welding methods.

The connection member 50 may be, for example, an electrical wire. In addition, the connection member 50 may be made of a material having elasticity or flexibility. By means of this connection member 50, it is possible to check and manage whether the voltage, temperature, and current of the plurality of battery cells C are normal. That is, information such as the voltage, the current, and the temperature received by the first protection circuit module from connection tabs adjacent to the first protection circuit module and information such as the voltage, the current, and the temperature received by the second protection circuit module from connection tabs adjacent to the second protection circuit module may be integrated and managed by the protection circuit module through the connection member.

In addition, when the battery cell C swells, shocks are absorbed by the elasticity or flexibility of the connection member 50, thereby advantageously preventing the first and second protection circuit modules 30a and 30b from being damaged.

In addition, a shape and structure of the connection member 50 are not limited to the shape and structure illustrated in FIG. 1.

In this way, since the protection circuit module 30 is provided with the first and second protection circuit modules 30a and 30b, the area of the PCB constituting the protection circuit module can be minimized, thereby securing space inside the battery module. Securing space inside the battery module improves work efficiency by facilitating not only the fastening work of connecting the connection tab 20 and the protection circuit module 30, but also repairs when an abnormality is detected in the battery module.

### [Battery Pack]

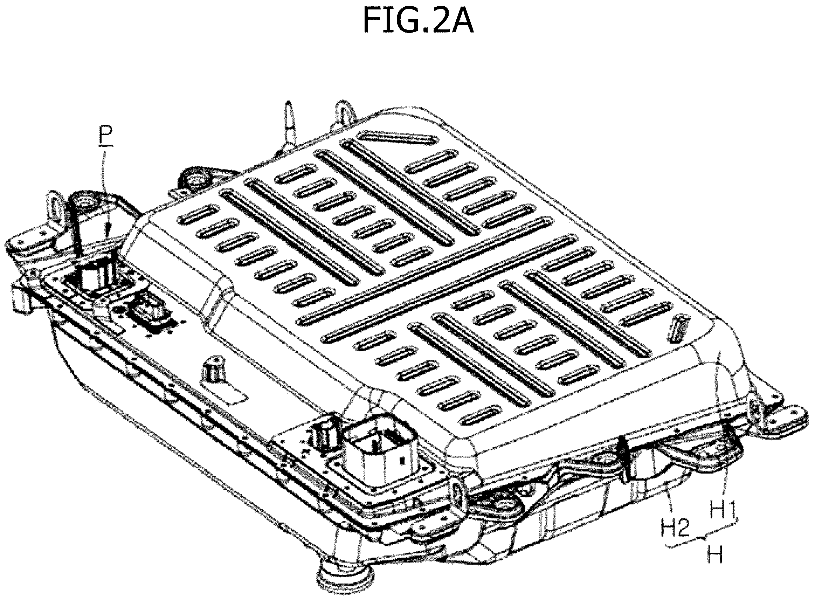

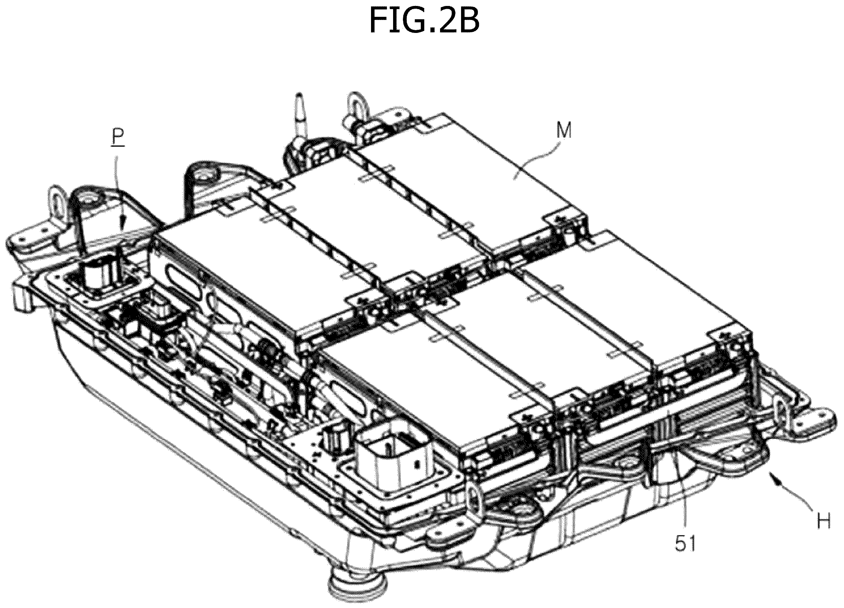

FIGS. 2A and 2B are exemplary diagrams illustrating a battery pack according to a preferred embodiment of the present disclosure (Although the same reference numerals as those in other drawings may be indicated in FIGS. 2A and 2B, it should be noted that the reference numerals indicated in FIGS. 2A and 2B are used in a closed manner within FIGS. 2A and 2B).

A battery pack P may include a plurality of battery modules M and a housing H for accommodating the plurality of battery modules M. For example, the housing H may include first and second housings H1 and H2 that are coupled in a direction facing each other after a plurality of battery modules M are interposed therebetween. The plurality of battery modules M may be electrically connected to each other using a busbar 51, and the plurality of battery modules M may be electrically connected to each other in a series/parallel or series-parallel mixed manner to obtain a required electrical output.

Based on the battery structure described herein, hereinafter, the apparatus and method for generating an open circuit voltage according to the present embodiment will be described in detail.

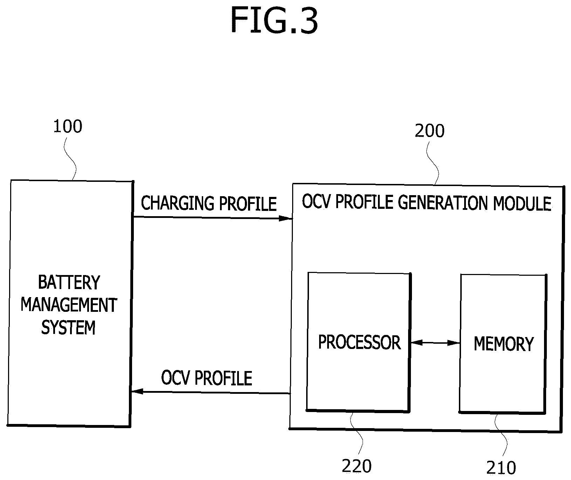

FIG. 3 illustrates a block diagram of an apparatus for generating an OCV profile according to embodiments of the present disclosure.

Referring to FIG. 3, the apparatus for generating the open circuit voltage profile according to embodiments of the present disclosure may include a BMS 100 and an OCV profile generation module 200.

The BMS 100 may measure a voltage value of each battery cell C and control each battery cell C based on the measured voltage value.

The BMS 100 may charge the battery cell C and generate a charging profile.

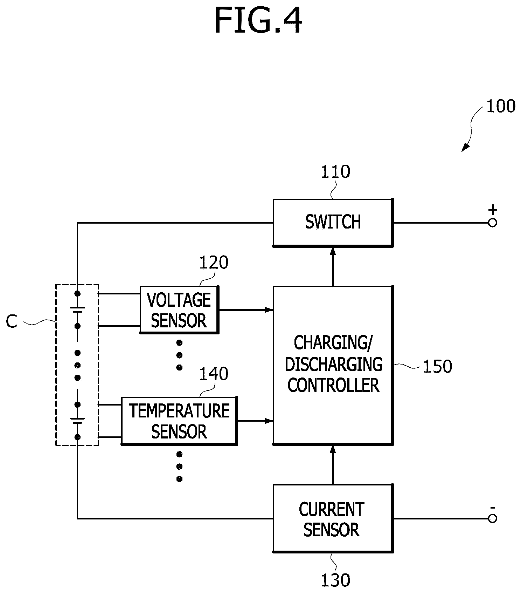

FIG. 4 illustrates a block diagram of a BMS according to embodiments of the present disclosure.

Referring to FIG. 4, the BMS 100 may include a switch 110, a voltage sensor 120, a current sensor 130, a temperature sensor 140, and a charging/discharging controller 150.

The switch 110 may control an electrical connection between the battery cell C and an external device. The switch 110 may be turned on according to a control signal of the charging/discharging controller 150 to electrically connect the battery cell C and the external device. In this case, the battery cell C may supply power to the external device or may be charged by receiving power from the external device. The switch 110 may be turned off according to the control signal of the charging/discharging controller 150 to electrically disconnect the battery cell C and the external device.

The switch 110 may be installed between a positive electrode of the battery cell C and the external device or may be installed between a negative electrode of the battery cell C and the external device. An installation location of the switch 110 is not particularly limited. The switch 110 may be implemented as a field effect transistor (FET) or a relay.

The battery cell C may be connected in series with a terminal of the external device.

The battery cell C may supply power to the external device or may be charged by receiving power from the external device.

The external device may be a portable device such as a mobile phone, a laptop computer, a digital camera, a video camera, a tablet computer, and a power tool, etc., as well as any of various electric power-driven power devices such as electric bicycles, electric motorcycles, electric vehicles, and hybrid vehicles, but is not particularly limited.

The voltage sensor 120 may be connected to each of the positive electrode and the negative electrode of the battery cell C to detect the voltage of the battery cell C and may input the detected voltage of the battery cell C to the charging/discharging controller 150.

The current sensor 130 is connected between the negative electrode of the battery cell C and the external device to detect the current when the battery cell C is charged or discharged and may input the detected current to the charging/discharging controller 150. The current sensor 130 may be a Hall current transformer (CT) that measures the current using a Hall element and outputs an analog current signal corresponding to the measured current, or may be implemented as a shunt resistor.

The temperature sensor 140 may detect the temperature of the battery cell C.

In the present embodiment, the arrangement structure, type, and operation method of the switch 110, voltage sensor 120, current sensor 130, and temperature sensor 140 of the BMS 100 are shown as examples and are not particularly limited.

The charging/discharging controller 150 may inform the remaining usage of a battery or a battery state through the state of charge (SOC) or the state of health (SOH).The state of health (SOH) may be defined as the ratio of the maximum battery charge to its rated capacity. The state of charge (SOC) may be defined as the ratio of the remaining charge in the battery, divided by the maximum charge that can be delivered by the battery. The charging/discharging controller 150 may be implemented as an analog front-end (AFE) or a micro controller unit (MCU).

The charging/discharging controller 150 may store an OCV profile that indicates the correspondence between the OCV and the SOC to calculate the SOC, the SOH, or the like, and may calculate the SOC, the SOH, or the like using the OCV profile. However, since the battery degrades over time, the charging/discharging controller 150 needs to correct the OCV profile in response to a degradation state of the battery. Accordingly, the charging/discharging controller 150 may receive and correct the OCV profile from the OCV profile generation module 200 and calculate the SOC or SOH using the corrected OCV profile.

The charging/discharging controller 150 may control the switch 110 to control the charging/discharging of the battery cell C.

The charging/discharging controller 150 may obtain charging information of the battery cell C while controlling the charging/discharging of the battery cell C.

The charging information of the battery cell C may include at least one of the voltage of the battery cell C, the current of the battery cell C, a degradation degree of the battery cell C, the SOC of the battery cell C, and the temperature of the battery cell C.

The degradation degree of the battery cell C may mean a cumulative usage amount or usage period of the battery cell C. In general, as the usage time of the battery cell C increases, the impedance inside the battery cell C increases, and thus, degradation may progress. Therefore, the charging/discharging controller 150 may determine the degradation degree of the battery cell C based on the cumulative usage amount and usage period of the battery cell C. In addition, the charging/discharging controller 150 may calculate the degradation degree of the battery cell in various ways using an initial charge state of the battery cell C, the temperature of the battery cell C, the charging time of the battery cell C, and the like.

The charging/discharging controller 150 may calculate the SOC of the battery cell C using the OCV profile.

The charging/discharging controller 150 may obtain the voltage, the current, and the temperature of the battery cell C through the voltage sensor 120, the current sensor 130, and the temperature sensor 140, respectively.

When charging is started, the charging/discharging controller 150 may determine whether charging information satisfies preset diagnostic charging conditions. As a result of the determination, when it is determined that the charging information satisfies the diagnostic charging conditions, the charging/discharging controller 150 may enter a diagnostic charging mode.

The diagnostic charging conditions may be set to determine whether the degradation of the battery cell C progresses and correction of the OCV profile is needed, thus ensuring a high precision with respect to the degradation of the battery cell C.

The charging information that serves as a criterion for determining the diagnostic charging conditions may include the degradation degree of the battery cell C, the SOC of the battery cell C, and the temperature of the battery cell C. Accordingly, the charging/discharging controller 150 may determine whether each of the degradation degree, SOC, and temperature of the battery cell C satisfies the diagnostic charging conditions set for each of the degradation degree, SOC, and temperature of the battery cell C. Here, any charging information that serves as a criterion for determining the diagnostic charging conditions may be adopted as long as the degradation of the battery cell C may be estimated using the charging information.

First, the charging/discharging controller 150 may determine that the diagnostic charging conditions are satisfied when the degradation degree of the battery cell C exceeds a set degradation degree. The degradation degree of the battery cell C may include the cumulative usage amount or usage period of the battery cell C.

The charging/discharging controller 150 may determine that the diagnostic charging conditions are satisfied when the SOC of the battery cell C is less than a set SOC. In this case, when the SOC of the battery cell C is greater than or equal to the set SOC, the charging/discharging controller 150 may additionally discharge the battery cell C so that an SOC range of the battery cell C becomes less than the set SOC.

The charging/discharging controller 150 may determine that the diagnostic charging conditions are satisfied when the temperature of the battery cell C is within a set temperature range. In this case, when it is determined that the temperature of the battery cell C is not within the set temperature range, the charging/discharging controller 150 may control charging and discharging through the switch 110 to adjust the temperature of the battery cell C to be within the set temperature range.

As a determination result of whether the charging information satisfies the diagnostic charging conditions, when it is determined that the charging information does not satisfy the diagnostic charging conditions, the charging/discharging controller 150 may operate in a normal charging mode.

As the determination result of whether the charging information satisfies the diagnostic charging conditions, when it is determined that the charging information satisfies the diagnostic charging conditions, the charging/discharging controller 150 may enter the diagnostic charging mode.

In the diagnostic charging mode, the charging/discharging controller 150 may control the switch 110 to charge the battery cell C with a low rate constant current (CC) in a preset range, for example, 0.1 C or less, until fully charged. In this case, the charging/discharging controller 150 may detect the voltage, the current, and the temperature of the battery cell C using the voltage sensor 120, the current sensor 130, and the temperature sensor 140.

The charging/discharging controller 150 may collect the voltage, the current, and the temperature of the battery cell C until the battery cell C is fully charged by charging the battery cell C with the low rate CC and generate a charging profile.

The charging/discharging controller 150 may transmit the generated charging profile to the OCV profile generation module 200.

In the present embodiment, the charging/discharging controller 150 and the OCV profile generation module 200 may be implemented as separate hardware, but the OCV profile generation module 200 may be mounted within the BMS 100 or implemented integrally with the charging/discharging controller 150.

Meanwhile, the charging/discharging controller 150 may receive the OCV profile from the OCV profile generation module 200. The charging/discharging controller 150 may calculate the SOC, the SOH, or the like using the received OCV profile. The OCV profile transmitted to the charging/discharging controller 150 may be an OCV profile newly generated by the OCV profile generation module 200.

The OCV profile generation module 200 may receive the charging profile from the charging/discharging controller 150. The OCV profile generation module 200 may analyze the charging profile to derive degradation information of the battery cell C and may generate the OCV profile of the battery cell C based on the derived degradation information.

The degradation information is information on a degradation state of each battery cell C and may be a quantitative result obtained through differential analysis that will be described herein. The degradation information will be described herein.

The OCV profile generation module 200 may include a memory 210 and a processor 220.

The memory 210 may store various types of data used by the processor 220. The data may include instructions for performing operations or actions according to embodiments of the present disclosure. That is, the memory 210 may store instructions for generating the OCV profile according to the battery cell C that has degraded under actual use conditions.

The memory 210 may include at least one storage medium among a flash memory type, a hard disk type, a multimedia card micro type, a card type memory, a random access memory (RAM), a static random access memory (SRAM), a read-only memory (ROM), a programmable read-only memory (PROM), an erasable programmable read-only memory (EPROM), and an electrically erasable programmable read-only memory (EEPROM).

The processor 220 may be connected to the memory 210 and may execute the instructions stored in the memory 210. The processor 220 may control at least one other component (e.g., hardware or software component) connected to the processor 220 by executing the instructions stored in the memory 210 and may perform various types of data processing or various computations.

In addition, the processor 220 may be configured such that a configuration for performing each function is divided at a hardware, software, or logic level. In this case, dedicated hardware for performing each function may be used. To this end, the processor 220 may be implemented as at least one of an application specific integrated circuit (ASIC), a digital signal processor (DSP), a programmable logic device (PLD), a field programmable gate array (FPGA), a central processing unit (CPU), a microcontroller, and/or a microprocessor, or may include at least one of these components.

The processor 220 may be implemented as a CPU or a system on chip (SoC) and may control a plurality of hardware or software components connected to the processor 220 by driving an operating system or an application and may perform various types of data processing and various computations. The processor 220 may be configured to execute at least one instruction stored in the memory 210 and store the execution result data in the memory 210.

The processor 220 may derive the degradation information using the charging profile and generate the OCV profile using the degradation information and state information of the battery cell C.

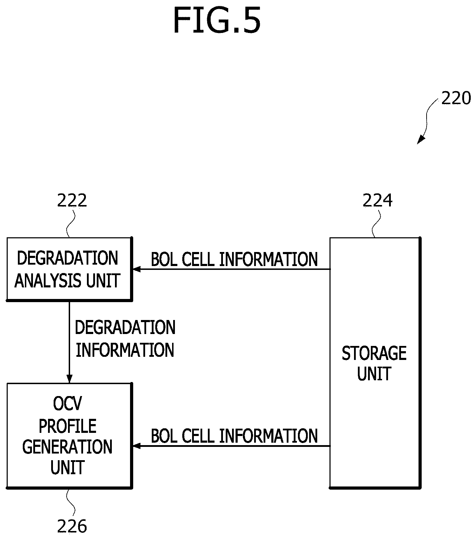

FIG. 5 illustrates a block diagram of a processor according to embodiments of the present disclosure.

Referring to FIG. 5, the processor 220 may include a degradation analysis unit 222, a storage unit 224, and an OCV profile generation unit 226.

The storage unit 224 may store state information required for degradation analysis and OCV profile generation. For example, the storage unit 224 may store beginning-of-life (BOL) cell information. The BOL cell information may include a positive electrode OCV profile of a BOL cell, a negative electrode OCV profile of the BOL cell, and a low rate-CC-charging profile at each temperature of the BOL cell but is not particularly limited.

The degradation analysis unit 222 may receive the charging profile from the BMS 100 and may receive the BOL cell information from the storage unit 224.

The degradation analysis unit 222 may convert the charging profile into a differential profile using the BOL cell information. The degradation analysis unit 222 may convert the charging profile into a differential voltage profile indicating a correspondence between differential voltages (dV/dQ), or a differential capacity profile indicating a correspondence between the voltage V and the differential capacity (dQ/dV).

The degradation analysis unit 222 may derive the degradation information by performing differential analysis on the differential profile. That is, the degradation analysis unit 222 may derive degradation information of each battery cell C by performing differential voltage analysis (DVA) on the differential voltage profile or performing incremental capacity analysis (ICV) on the differential capacity profile using the BOL cell information.

The degradation information is a degradation parameter of the battery cell C, and the degradation information may include an amount of positive electrode active material loss and usage range of the battery cell C and an amount of negative electrode active material loss and usage range of the battery cell C, and is not particularly limited.

The OCV profile generation unit 226 may receive the degradation information of the battery cell C from the degradation analysis unit 222 and may receive the BOL cell information from the storage unit 224.

The OCV profile generation unit 226 may newly generate an OCV profile of each battery cell C using BOL cell information, for example, an OCV profile of a positive electrode and an OCV profile of a negative electrode, and degradation information of the battery cell C.

The OCV profile generated by the OCV profile generation unit 226 is generated by reflecting degradation information derived based on an actual usage environment as described herein, and thus may reduce errors in calculations of the SOC or SOH.

In the present embodiment, in order to help understand the embodiment, although the degradation analysis unit 222, storage unit 224, and OCV profile generation unit 226 are described as separate components within the processor 220, but depending on the embodiment, the processor 220 may be implemented to have a configuration in which functions of sub-components thereof are performed in an integrated manner.

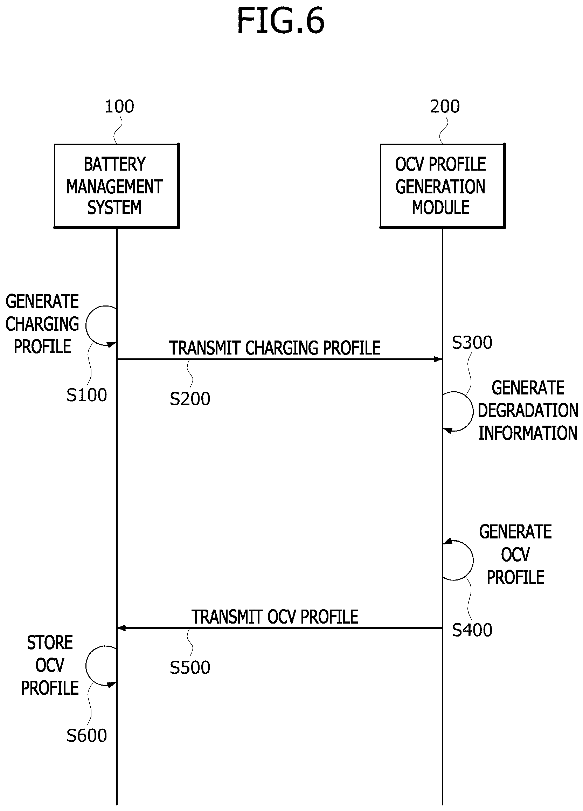

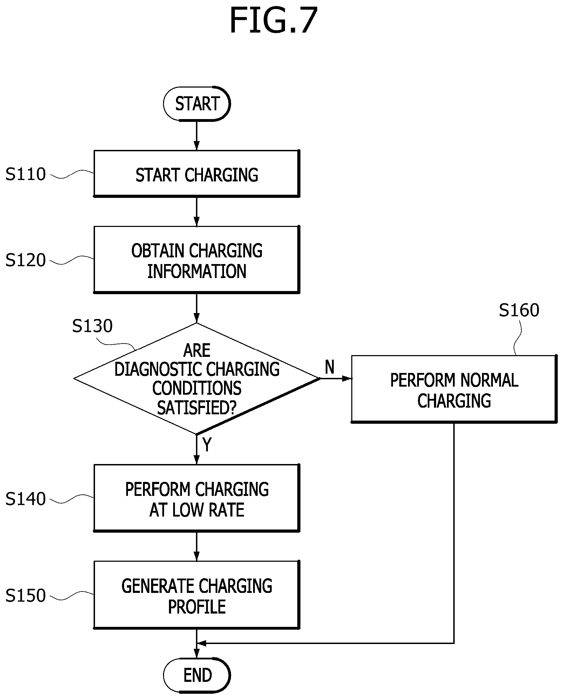

Hereinafter, a method of generating an open circuit voltage profile according to embodiments of the present disclosure will be described in detail with reference to FIGS. 6 and 7.

FIG. 6 illustrates a flowchart of a method of generating an OCV profile according to embodiments of the present disclosure.

Referring to FIG. 6, the BMS 100 may generate a charging profile (S100).

FIG. 7 illustrates a flowchart of a charging profile generation process according to embodiments of the present disclosure.

Referring to FIG. 7, first, the BMS 100 starts charging (S110) and may obtain charging information during a charging process (S120). The charging information may include a degradation degree of the battery cell C, the SOC of the battery cell C, and the temperature of the battery cell C.

Upon obtaining the charging information, the BMS 100 may determine whether the corresponding charging information satisfies preset diagnostic charging conditions (S130).

When the degradation degree of the battery cell C exceeds a preset degradation degree, the SOC of the battery cell C is less than the preset SOC, or the temperature of the battery cell C is within a preset temperature range, the BMS 100 may determine that the diagnostic charging conditions are satisfied.

When the determination result at operation S130 indicates that the charging information does not satisfy the diagnostic charging conditions, the BMS 100 may perform normal charging (S160).

When the determination result at step S130 indicates that the charging information satisfies the diagnostic charging conditions, the BMS 100 may enter a diagnostic charging mode. During the diagnostic charging mode, the BMS 100 may charge the battery cell with a low rate CC of 0.1 C or less (S140).

In the process of charging the battery cell C until fully charged, the BMS 100 may detect the voltage, the current, and the temperature of the battery cell C and generate a charging profile (S150).

The BMS 100 may transmit the generated charging profile to the OCV profile generation module 200 (S160).

The OCV profile generation module 200 may receive the charging profile from the charging/discharging controller 150 and convert the charging profile into a differential profile. The OCV profile generation module 200 may convert the charging profile into a differential voltage profile or a differential capacity profile using BOL cell information.

The OCV profile generation module 200 may derive degradation information by performing differential analysis on the differential profile. In this case, that is, the OCV profile generation module 200 may generate the degradation information of each battery cell C by performing the DVA analysis on the differential voltage profile or performing the ICV analysis on the differential capacity profile using the BOL cell information (S300).

The degradation information may include the amount of positive electrode active material loss and usage range of the battery cell C, and the amount of negative electrode active material loss and usage range of the battery cell C.

The OCV profile generation module 200 may generate an OCV profile of each battery cell C using an OCV profile of the positive electrode, an OCV profile of the negative electrode, and degradation information of the battery cell C (S400).

The OCV profile generation module 200 may transmit the generated OCV profile to the BMS 100 (S500).

The BMS 100 may store the OCV profile (S600). Accordingly, the BMS 100 may calculate the SOC or SOH using a newly stored OCV profile.

In embodiments of the present disclosure, the OCV profile generation module 200 may be implemented in a cloud environment.

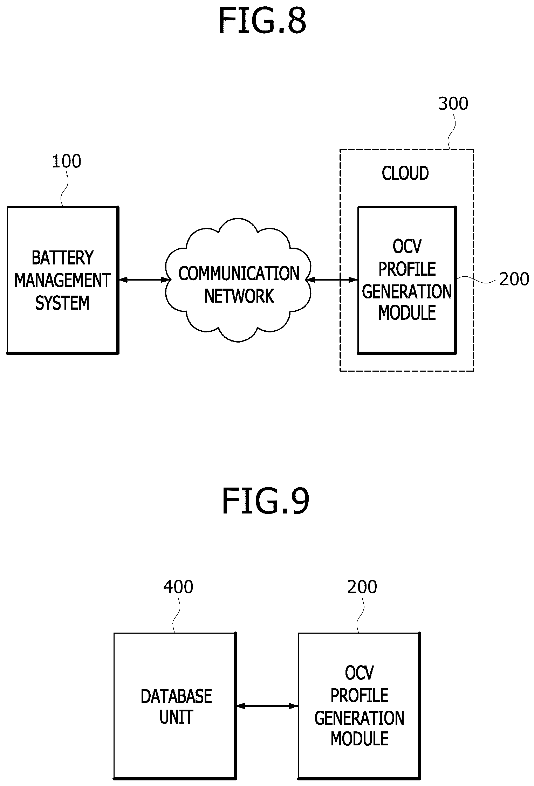

FIG. 8 illustrates a block diagram of an apparatus for generating an open circuit voltage profile according to embodiments of the present disclosure.

Referring to FIG. 8, the OCV profile generation module 200 may be installed in a cloud system 300 and connected to the BMS 100 via a communication network.

The communication network may employ 3^{rd} Generation Partnership Project (3GPP), Long Term Evolution (LTE), 5G, Worldwide Interoperability for Microwave Access (WiMAX), wired and wireless Internet, a local area network (LAN), a wireless local area network (Wireless LAN), a wide area network (WAN), a personal area network (PAN), Bluetooth, Wireless Fidelity (Wifi), etc., and is not particularly limited.

In this case, the OCV profile generation module 200 may be connected to a plurality of BMSs 100, generate an OCV profile for each BMS 100, and transmit the generated OCV profile to each BMS 100.

In addition, the OCV profile generation module 200 stores the OCV profile through the cloud so that the OCV profile may be utilized when the battery is reused.

FIG. 9 illustrates a block diagram of an apparatus for generating an open circuit voltage profile according to embodiments of the present disclosure.

Referring to FIG. 9, in embodiments of the present disclosure, a database unit 400 that stores a charging profile may be included.

In the embodiments described herein, the BMS 100 actually charges the battery cell C and generates the charging profile based on this charging. This actual charging by the BMS 100 has the advantage of being able to obtain a new OCV profile within a day, but it may take time depending on the actual charging.

The database unit 400 and the OCV profile generation module 200 may be connected to each other. The database unit 400 may store charging profiles of the BMS 100 for each type in advance and transmit these charging profiles to the OCV profile generation module 200. Accordingly, the OCV profile generation module 200 may quickly generate an OCV profile for each BMS 100 using the charging profiles stored in the database unit 400 and transmit the OCV profile it to each BMS 100.

In this way, according to the present disclosure, the OCV profile can be generated according to the battery cell C that has degraded under actual use conditions, thereby advantageously reducing errors in calculations of the SOC, the SOH, or the like.

In addition, according to the present disclosure, a new OCV profile can be generated within a day using the charging time of the battery cell C.

In addition, according to the present disclosure, the degradation state of the battery cell C can be quantified to generate an OCV profile suitable for each degradation state.

In addition, according to the present disclosure, an OCV profile can be stored in the cloud so that the corresponding OCV profile can be utilized when the battery is reused.

However, effects that can be achieved through the present disclosure are not limited to the herein-described effects and other effects that are not described may be clearly understood by those skilled in the art from the herein detailed description.

The embodiments described herein may be implemented, for example, as a method or process, a device, a software program, a data stream, or a signal. Although discussed in the context of a single type of implementation (for example, discussed only as a method), features discussed herein may also be implemented in other forms (for example, a device or a program). The device may be implemented by suitable hardware, software, firmware, and the like. The method may be implemented on a device, such as a processor that generally refers to a processing device including a computer, a microprocessor, an integrated circuit, a programmable logic device, etc. The processor includes a communication device such as a computer, a cell phone, a personal digital assistant (PDA), and other devices that facilitate communication of information between the device and end-users.

Although the present disclosure has been described with reference to embodiments and drawings illustrating aspects thereof, the present disclosure is not limited thereto. Various modifications and variations can be made by a person skilled in the art to which the present disclosure belongs within the scope of the present disclosure and the claims and their equivalents, herein.

## Claims

1. An apparatus for generating an open circuit voltage, OCV, profile, comprising:
a battery management system that generates a charging profile by charging a battery cell (10a, 10b); and
an OCV profile generation module (200) that analyzes the charging profile to derive degradation information of the battery cell (10a, 10b) and generates the OCV profile of the battery cell (10a, 10b) based on the degradation information.

2. The apparatus of claim 1, wherein the degradation information includes at least one of an amount of positive electrode active material loss and usage range of the battery cell (10a, 10b) and an amount of negative electrode active material loss and usage range of the battery cell (10a, 10b).

3. The apparatus of claim 1 or 2, wherein the battery management system charges the battery cell (10a, 10b) depending on whether at least one of a degradation degree, a state of charge, SOC, and a temperature of the battery cell (10a, 10b) satisfies preset diagnostic charging conditions.

4. The apparatus of claims 1 to 3, wherein the battery management system charges the battery cell (10a, 10b) at a low rate in a preset range until fully charged.

5. The apparatus of claims 1 to 4, wherein the battery management system includes:
a relay that controls an electrical connection between the battery cell (10a, 10b) and an external device;
a voltage sensor (120) that detects a voltage of the battery cell (10a, 10b);
a current sensor (130) that detects a current of the battery cell (10a, 10b);
a temperature sensor (140) that detects a temperature of the battery cell (10a, 10b); and
a charging/discharging controller (150) that controls charging/discharging of the battery cell (10a, 10b) through the relay, derives the charging profile based on at least one of the voltage, the current, and the temperature of the battery cell (10a, 10b), and transmits the charging profile to the OCV profile generation module (200).

6. The apparatus of claims 1 to 5, wherein the OCV profile generation module (200) includes:
a processor (220); and
a memory (210) that stores instructions executed by the processor (220), and
the processor (220) derives the degradation information using the charging profile and generates the OCV profile using the degradation information and state information of the battery cell (10a, 10b).

7. The apparatus of claim 6, wherein the processor (220) converts the charging profile into a differential profile and differentially analyzes the differential profile to derive the degradation information.

8. An apparatus for generating an open circuit voltage, OCV, profile, comprising:
a processor (220); and
a memory (210) that stores instructions executed by the processor (220),
wherein the processor (220) in executing the instructions analyzes the charging profile to derive degradation information of the battery cell (10a, 10b) and generates an OCV profile of the battery cell (10a, 10b) based on the degradation information.

9. The apparatus of claim 8, wherein the degradation information includes at least one of an amount of positive electrode active material loss and usage range of the battery cell (10a, 10b) and an amount of negative electrode active material loss and usage range of the battery cell (10a, 10b).

10. The apparatus of claim 8 or 9, wherein the charging profile includes at least one of a voltage, a current, and a temperature of the battery cell (10a, 10b).

11. A method of generating an open circuit voltage, OCV, profile, comprising:
generating, by a battery management system, a charging profile by charging a battery cell (10a, 10b);
deriving, by an OCV profile generation module (200), degradation information using the charging profile; and
generating, by the OCV profile generation module (200), the OCV profile using the degradation information and state information of the battery cell (10a, 10b).

12. The method of claim 11, wherein, in the generating of the charging profile, the battery management system charges the battery cell (10a, 10b) depending on whether at least one of a degradation degree, a state of charge, SOC, and a temperature of the battery cell (10a, 10b) satisfies preset diagnostic charging conditions.

13. The method of claim 11 or 12, wherein, in the generating of the charging profile, the battery management system charges the battery cell (10a, 10b) at a low rate in a preset range until fully charged.

14. The method of claims 11 to 13, wherein the degradation information includes at least one of an amount of positive electrode active material loss and usage range of the battery cell (10a, 10b) and an amount of negative electrode active material loss and usage range of the battery cell (10a, 10b).

15. The method of claims 11 to 14, wherein, in the deriving of the degradation information, the OCV profile generation module (200) converts the charging profile into a differential profile and differentially analyzes the differential profile to derive the degradation information
